# EUROPEAN PATENT APPLICATION

(11) **EP 4 571 342 A1**
(43) Date of publication of application: **18.06.2025**
(21) Application number: 23865725.8
(22) Date of filing: 02.08.2023
(51) Int. Cl.: G01R 31/392, G01R 31/3842, G01R 31/389, G01R 27/08, G01R 31/36, G01R 31/374, G01R 31/396, G08B 21/18, H01M 10/42, G06F 1/16

(54) **FOLDABLE DEVICE CONTROLLING CHARGING OF BATTERY CELLS, AND METHOD THEREFOR**

(30) Priority: 16.09.2022 KR 20220117141; 03.11.2022 KR 20220145169
(71) Applicant: Samsung Electronics Co., Ltd., Suwon-si, Gyeonggi-do 16677 (KR)
(72) Inventor: LEE, Jehwan, Suwon-si Gyeonggi-do 16677 (KR)
(74) Representative: Appleyard Lees IP LLP
(86) International application number: PCT/KR2023/011311
(87) International publication number: WO 2024/058425

(57) **Abstract**

Provided are a foldable device controlling charging of battery cells, and a method therefor. The foldable device comprises: a first battery pack which is accommodated in a first housing structure and comprises a first battery cell; a second battery pack which is accommodated in a second housing structure and comprises a second battery cell; a connection part for connecting the first battery cell and the second battery cell in series; and a fuel gauge which is accommodated in the first housing structure and detects a first cell voltage of the first battery cell and a second cell voltage of the second battery cell, wherein wiring connected to a negative electrode terminal of the first battery cell and wiring connected to a positive electrode terminal of the second battery cell are connected to the fuel gauge, and the fuel gauge detects IR voltage between the negative electrode terminal of the first battery cell and the positive electrode terminal of the second battery cell separately from the first cell voltage and the second cell voltage.

## Description

### [Technical Field]

The disclosure relates to a foldable device controlling the charging of battery cells, and a method therefor.

### [Background Art]

Generally, in a foldable device, when a plurality of battery cells are connected in series and used, a plurality of battery packs are configured by closely arranging the battery cells, and the plurality of battery packs are distributed and arranged in a plurality of housings corresponding to a plurality of surfaces of the foldable device.

Conventionally, there has been a problem in that it is difficult to accurately detect cell voltages of the battery cells within the plurality of battery packs distributed and arranged, and in particular, a problem occurs in which wiring connecting the plurality of battery packs distributed and arranged is damaged as the folding and unfolding operations of the foldable device are repeated.

### [Disclosure of Invention]

### [Technical Solution]

One aspect of the disclosure may provide a foldable device including a housing unit which includes a first housing structure and a second housing structure connected using a hinge, a first battery pack which is accommodated in the first housing structure and includes a first battery cell, a second battery pack which is accommodated in the second housing structure and includes a second battery cell, a connection unit configured to connect the first battery cell to the second battery cell in series via between the first housing structure and the second housing structure, and a fuel gauge which is accommodated in the first housing structure and detects a first cell voltage of the first battery cell and a second cell voltage of the second battery cell, wherein a negative electrode terminal of the first battery cell is electrically connected to a positive electrode terminal of the second battery cell through the connection unit, wiring connected to the negative electrode terminal of the first battery cell and wiring connected to the positive electrode terminal of the second battery cell are each connected to the fuel gauge, and the fuel gauge detects an IR voltage between the negative electrode terminal of the first battery cell and the positive electrode terminal of the second battery cell separately from the first cell voltage and the second cell voltage, by using the wiring connected to the negative electrode terminal of the first battery cell and the wiring connected to the positive electrode terminal of the second battery cell.

In addition, a second aspect of the disclosure may provide a method for managing a battery in a foldable device, including detecting cell voltages of battery cells within a first battery pack accommodated in a first housing structure of the foldable device and a second battery pack accommodated in a second housing structure of the foldable device, wherein the first housing structure is connected to the second housing structure through a hinge, the first battery pack includes a first battery cell, and the second battery pack includes a second battery cell, and detecting an IR voltage of a power line including a connection unit connecting the first battery cell to the second battery cell in series via between the first housing structure and the second housing structure, wherein a negative electrode terminal of the first battery cell is electrically connected to a positive electrode terminal of the second battery cell through the connection unit, wherein detecting the IR voltage includes detecting the IR voltage between the negative electrode terminal of the first battery cell and the positive electrode terminal of the second battery cell separately from the cell voltages, by using wiring connecting a fuel gauge of the foldable device to the negative electrode terminal of the first battery cell, and wiring connecting the fuel gauge to the positive electrode terminal of the second battery cell.

### [BRIEF DESCRIPTION OF DRAWINGS]

FIG. 1 is a diagram illustrating an unfolding state of a foldable device according to various embodiments of the disclosure.
FIG. 2 is a diagram illustrating a folding state of the foldable device of FIG. 1 according to various embodiments of the disclosure.
FIG. 3 is an exploded perspective view of a foldable device according to various embodiments of the disclosure.
FIG. 4 is a block diagram of a foldable device including a first battery pack and a second battery pack according to an embodiment.
FIG. 5 is a block diagram of a foldable device for explaining a process of detecting cell voltages of battery cells within a first battery pack and a second battery pack and controlling the charging/discharging of the battery cells according to an embodiment.
FIG. 6 is a diagram for explaining a detection path added for the sake of detecting cell voltages of battery cells according to an embodiment.
FIG. 7 is a diagram showing an example of detecting cell voltages of battery cells when the battery cells are charged according to an embodiment of the disclosure.
FIG. 8 is a diagram showing an example of detecting cell voltages of battery cells when the battery cells are discharged according to an embodiment of the disclosure.
FIG. 9A is a diagram showing an example in which a first battery pack 191 and a second battery pack 192 each include one battery cell according to an embodiment.
FIG. 9B is a diagram showing an example in which a first battery pack 191 includes two battery cells and a second battery pack 192 includes one battery cell according to an embodiment.
FIG. 9C is a diagram showing an example in which a first battery pack 191 includes one battery cell and a second battery pack 192 includes two battery cells according to an embodiment.
FIG. 10 is a flowchart of a method in which a foldable device manages the state of battery cells according to an embodiment.
FIG. 11 is a block diagram of an electronic device 1001 in a network environment 1000 according to various embodiments.

### [Mode for the Invention]

Embodiments of the disclosure will be described below in detail with reference to the attached drawings wherein the embodiments of the disclosure may be easily embodied by those skilled in the art to which the disclosure pertains. However, the disclosure may be implemented in various different forms and is not limited to the embodiments described herein. In addition, in order to clearly describe the disclosure in the drawings, portions not related to the description are omitted, and similar portions are given similar reference numerals throughout the specification.

The terms used in the disclosure are described as general terms currently used in consideration of functions mentioned in the disclosure, but they may mean various other terms depending on the intention of engineers engaged in the relevant field, precedents, the emergence of new technologies, etc. Therefore, the terms used in the disclosure should not be interpreted solely based on the names of the terms, but should be interpreted based on the meanings of the terms and the overall contents of the disclosure.

In addition, terms such as first, second, etc. may be used to describe various components, but the components should not be limited by these terms. These terms are used for the purpose of distinguishing one component from another.

Throughout the specification, when a portion is said to be "connected" to another portion, this includes not only a case where it is "directly connected" but also a case where it is "electrically connected" with another element located therebetween. In addition, when a portion is said to "include" a component, this does not mean excluding other components unless specifically stated otherwise, but rather means that it may further include other components.

Phrases such as "in an embodiment" appearing in various places in the disclosure do not necessarily all refer to the same embodiment.

An embodiment of the disclosure may be represented by functional block constructions and various processing steps. Some or all of these functional blocks may be implemented by various numbers of hardware and/or software constructions performing specific functions. For example, the functional blocks of the disclosure may be implemented by one or more microprocessors, or be implemented by circuit constructions for a certain function. Also, for example, the functional blocks of the disclosure may be implemented by various programming or scripting languages. The functional blocks may be implemented by algorithms that are executed in one or more processors. In addition, the disclosure may employ the conventional art for the sake of electronic environment settings, signal processing, and/or data processing, etc. Terms such as "mechanism," "element," "means," and "construction", etc. may be used broadly, and are not limited to mechanical and physical constructions.

In addition, connection lines or connection members between components illustrated in the drawings exemplarily merely represent functional connections and/or physical or circuit connections. In an actual device, connection between components may be represented by replaceable or added various functional connections, physical connections, or circuit connections.

The disclosure will be described below in detail with reference to the attached drawings.

A foldable device of an embodiment of the disclosure may include a housing unit which includes a first housing structure and a second housing structure connected using a hinge, a first battery pack which is accommodated in the first housing structure and includes a first battery cell, a second battery pack which is accommodated in the second housing structure and includes a second battery cell, a connection unit configured to connect the first battery cell to the second battery cell in series via between the first housing structure and the second housing structure, and a fuel gauge which is accommodated in the first housing structure and detects a first cell voltage of the first battery cell and a second cell voltage of the second battery cell. In addition, a negative electrode terminal of the first battery cell may be electrically connected to a positive electrode terminal of the second battery cell through the connection unit. In addition, wiring connected to the negative electrode terminal of the first battery cell and wiring connected to the positive electrode terminal of the second battery cell may be each connected to the fuel gauge. In addition, the fuel gauge may detect an IR voltage between the negative electrode terminal of the first battery cell and the positive electrode terminal of the second battery cell separately from the first cell voltage and the second cell voltage, by using the wiring connected to the negative electrode terminal of the first battery cell and the wiring connected to the positive electrode terminal of the second battery cell.

The IR voltage may be detected separately from the first cell voltage and the second cell voltage, whereby the cell voltages of the battery cells within the first battery pack and the second battery pack may be accurately detected regardless of the damage of the connection unit.

In addition, the fuel gauge may be included in the first battery pack accommodated in the first housing structure.

In addition, the fuel gauge may include an IR voltage detection module for detecting the IR voltage. In addition, the wiring connected to the negative electrode terminal of the first battery cell and the wiring connected to the positive electrode terminal of the second battery cell may be connected to the IR voltage detection module.

In addition, the fuel gauge may include a first cell voltage detection module for detecting the first cell voltage of the first battery cell, and a second cell voltage detection module for detecting the second cell voltage of the second battery cell.

In addition, the first cell voltage detection module may be connected to a positive electrode of the first battery cell and a negative electrode of the first battery cell. In addition, the second cell voltage detection module may be connected to a positive electrode of the second battery cell and a negative electrode of the second battery cell.

In addition, the foldable device may include a printed circuit board that is accommodated in the first housing structure and is connected to the first battery pack. In addition, the printed circuit board may include an embedded controller (EC) configured to control the charging of the battery cells within the first battery pack and the second battery pack, and a charging unit configured to present a charging power to the first battery pack under the control of the EC.

The EC may compensate a charging voltage for charging the battery cells within the first battery pack and the second battery pack, by using the IR voltage.

In addition, the fuel gauge may further include a micro controller unit (MCU) configured to register cell voltages detected from the first battery pack and the second battery pack.

In addition, the first battery pack may further include a charging FET (CFET) configured to turn on/off the charging of the battery cells within the first battery pack and the second battery pack, a discharging FET (DFET) configured to turn on/off the discharging of the battery cells within the first battery pack and the second battery pack, and a fuse configured to block a power path to the first battery pack.

In addition, the CFET, the DFET, and the fuse may be controlled by the MCU.

In addition, the MCU may obtain a current Is flowing in a resistor Rs between the second battery cell within the second battery pack and the ground, and the current Is may be used to determine that the connection unit is damaged.

In addition, the EC may identify a resistance Rc obtained by dividing the IR voltage by the obtained current Is, and output an alarm notifying a damage of the connection unit through an output unit of the foldable device when the identified resistance Rc exceeds a predefined range.

By monitoring a resistance of a power line including the connection unit by using the separately detected IR voltage, the damage or non-damage of the connection unit may be effectively determined, and the damage of the connection unit may be notified to a user.

A method for managing a battery in a foldable device of an embodiment of the disclosure may include detecting cell voltages of battery cells within a first battery pack accommodated in a first housing structure of the foldable device and a second battery pack accommodated in a second housing structure of the foldable device, wherein the first housing structure is connected to the second housing structure through a hinge, the first battery pack includes a first battery cell, and the second battery pack includes a second battery cell, and detecting an IR voltage of a power line including a connection unit connecting the first battery cell to the second battery cell in series via between the first housing structure and the second housing structure, wherein a negative electrode terminal of the first battery cell is electrically connected to a positive electrode terminal of the second battery cell through the connection unit. In addition, detecting the IR voltage may include detecting the IR voltage between the negative electrode terminal of the first battery cell and the positive electrode terminal of the second battery cell separately from the cell voltages, by using wiring connecting a fuel gauge of the foldable device to the negative electrode terminal of the first battery cell, and wiring connecting the fuel gauge to the positive electrode terminal of the second battery cell.

In addition, the fuel gauge may be included in the first battery pack accommodated in the first housing structure.

In addition, detecting the IR voltage may include detecting the IR voltage by using the fuel gauge including an IR voltage detection module for detecting the IR voltage. In addition, the wiring connecting the fuel gauge to the negative electrode terminal of the first battery cell and the wiring connecting the fuel gauge to the positive electrode terminal of the second battery cell may be connected to the IR voltage detection module.

In addition, detecting the cell voltages may include detecting the first cell voltage of the first battery cell by using a first cell voltage detection module included in the fuel gauge, and detecting the second cell voltage of the second battery cell by using a second cell voltage detection module included in the fuel gauge.

In addition, the first cell voltage detection module may be connected to a positive electrode of the first battery cell and a negative electrode of the first battery cell, and the second cell voltage detection module may be connected to a positive electrode of the second battery cell and a negative electrode of the second battery cell.

In addition, the method may further include compensating a charging voltage for charging the battery cells within the first battery pack and the second battery pack, by using the IR voltage.

In addition, the method may further include registering the cell voltages detected from the first battery pack and the second battery pack.

In addition, the method may further include obtaining a current Is flowing in a resistor Rs between the second battery cell within the second battery pack and the ground, and determining that the connection unit is damaged by using the current Is.

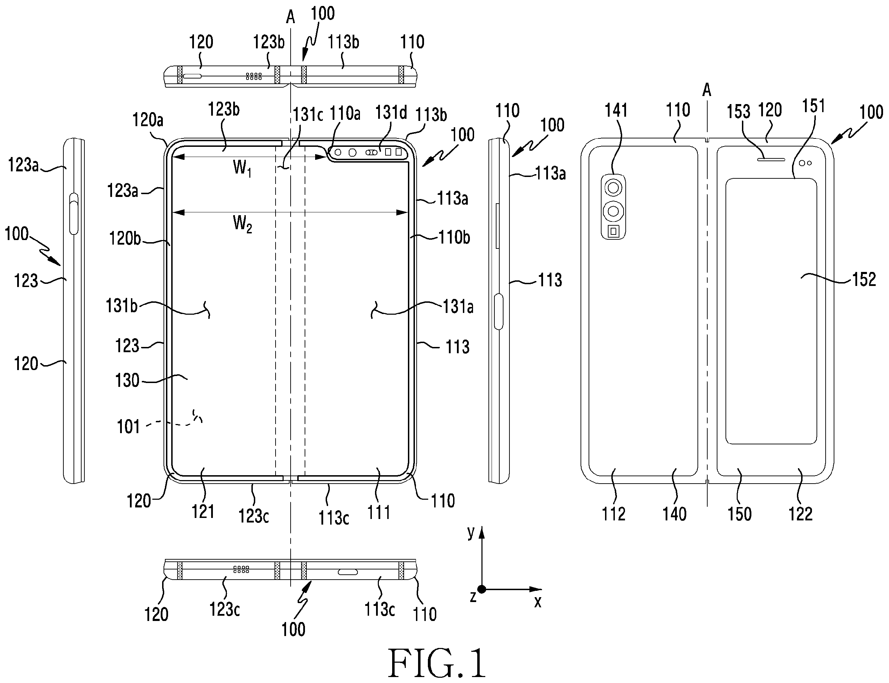

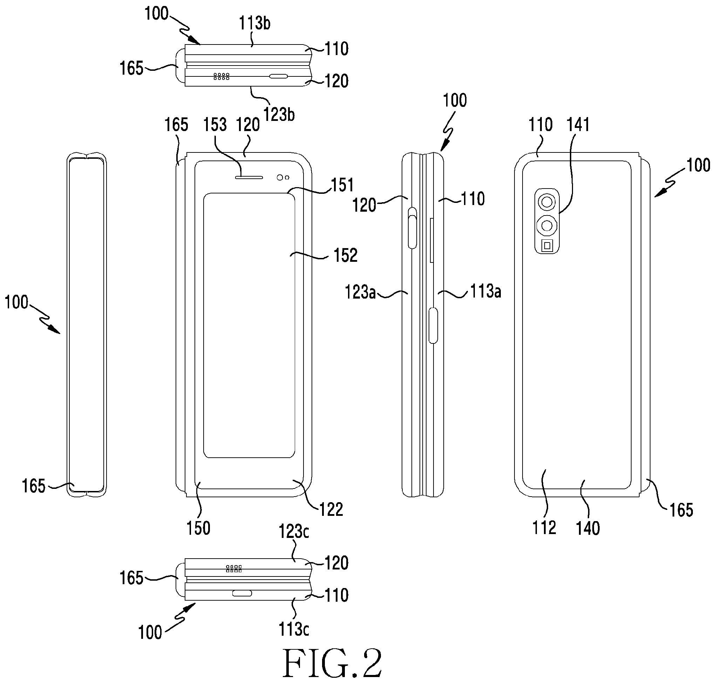

FIG. 1 is a diagram illustrating an unfolding state of a foldable device according to various embodiments of the disclosure. FIG. 2 is a diagram illustrating a folding state of the foldable device of FIG. 1 according to various embodiments of the disclosure.

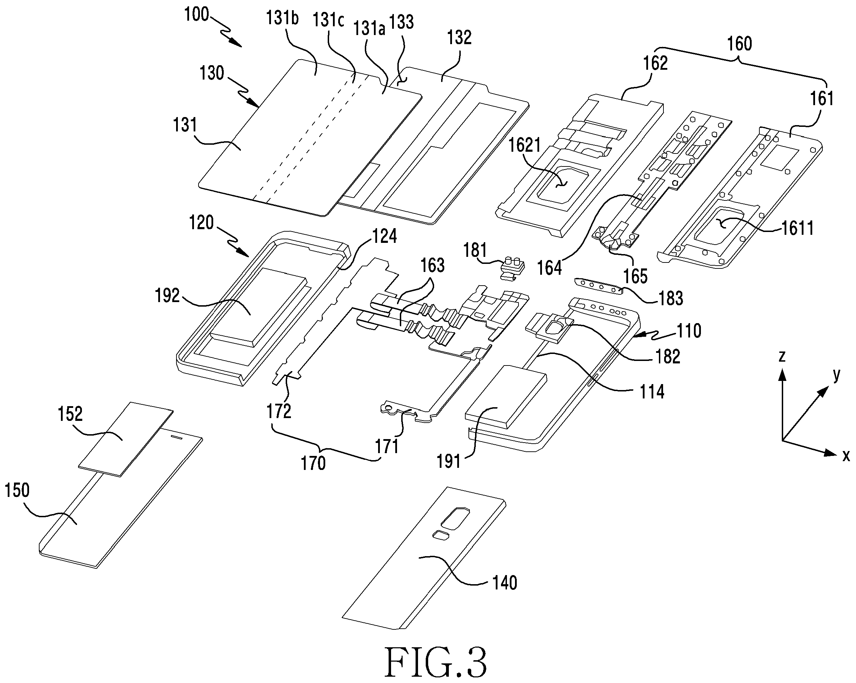

Referring to FIG. 1, the foldable device 100 may include a pair of housing structures 110 and 120 (e.g., foldable housing structures) rotatably coupled to each other through a hinge structure (e.g., hinge structure 164 of FIG. 3) to be folded with respect to each other, a hinge cover (e.g., hinge cover 165 of FIG. 2) covering a foldable portion of the pair of housing structures 110 and 120, and a display unit 130 (e.g., flexible display, foldable display, or first display) arranged in a space formed by the pair of housing structures 110 and 120. In this document, a surface on which the display unit 130 is arranged may be defined as a front surface of the foldable device 100, and a surface opposite to the front surface may be defined as a rear surface of the foldable device 100. In addition, a surface surrounding a space between the front surface and the rear surface may be defined as a side surface of the foldable device 100.

In an embodiment, the pair of housing structures 110 and 120 may include a first housing structure 110 including a sensor region 131d, a second housing structure 120, a first rear cover 140, and a second rear cover 150. The pair of housing structures 110 and 120 of the foldable device 100 are not limited to a form and coupling illustrated in FIGS. 1 and 2, and may be implemented by a combination and/or coupling of other shapes or portions. For example, in another embodiment, the first housing structure 110 and the first rear cover 140 may be formed integrally, and the second housing structure 120 and the second rear cover 150 may be formed integrally.

According to an embodiment, the first housing structure 110 and the second housing structure 120 may be arranged at both sides centering on a folding axis (A axis), and have an overall symmetrical shape with respect to the folding axis (A axis). According to an embodiment, an angle or distance between the first housing structure 110 and the second housing structure 120 may vary depending on whether the state of the foldable device 100 is a flat state or unfolding state, a folding state, or an intermediate state. According to an embodiment, unlike the second housing structure 120, the first housing structure 110 additionally includes the sensor region 131d in which various sensors are arranged, but may have a mutually symmetrical shape in other regions. In another embodiment, the sensor region 131d may be additionally arranged or replaced in at least a partial region of the second housing structure 120 as well.

In an embodiment, the foldable device 100 may operate in an in-folding manner and/or an out-folding manner, by allowing the first housing structure 110 to rotate in a range of 0 degrees to 360 degrees with respect to the second housing structure 120 through the hinge structure (e.g., hinge structure 164 of FIG. 3). According to various embodiments, the hinge structure 164 may be formed in a vertical direction or a horizontal direction when the foldable device 100 is viewed from the above. According to various embodiments, the hinge structure 164 may be plural. For example, all of a plurality of hinge structures may be arranged in the same direction. In another example, some of the plurality of hinge structures may be arranged and folded in different directions.

In an embodiment, the first housing structure 110 may be connected to the hinge structure (e.g., hinge structure 164 of FIG. 3) in the unfolding state of the foldable device 100, and include a first surface 111 arranged to face the front surface of the foldable device 100, a second surface 112 facing the opposite direction of the first surface 111, and a first side member 113 surrounding at least a portion of a space between the first surface 111 and the second surface 112. In an embodiment, the first side member 113 may include a first side surface 113a arranged parallel to the folding axis (A axis), a second side surface 113b extending from one end of the first side surface 113a in the direction perpendicular to the folding axis, and a third side surface 113c extending from the other end of the first side surface 113a in the direction perpendicular to the folding axis (A axis).

In an embodiment, the second housing structure 120 may be connected to the hinge structure (e.g., hinge structure 164 of FIG. 3) in the unfolding state of the foldable device 100, and include a third surface 121 arranged to face the front surface of the foldable device 100, a fourth surface 122 facing the opposite direction of the third surface 121, and a second side member 123 surrounding at least a portion of a space between the third surface 121 and the fourth surface 122. In an embodiment, the second side member 123 may include a fourth side surface 123a arranged parallel to the folding axis (A axis), a fifth side surface 123b extending from one end of the fourth side surface 123a in the direction perpendicular to the folding axis (A axis), and a sixth side surface 123c extending from the other end of the fourth side surface 123a in the direction perpendicular to the folding axis (A axis). In an embodiment, the third surface 121 may face the first surface 111 in the folding state.

In an embodiment, the foldable device 100 may include a recess 101 formed to accommodate the display unit 130 through a structural shape coupling of the first housing structure 110 and the second housing structure 120. The recess 101 may have substantially the same size as the display unit 130. In an embodiment, due to the sensor region 131d, the recess 101 may have two or more different widths in the direction perpendicular to the folding axis (A axis). For example, the recess 101 may have a first width W1 between a first portion 120a of the second housing structure 120 parallel to the folding axis (A axis) and a first portion 110a of the first housing structure 110 formed at a periphery of the sensor region 131d, and a second width W2 formed by a second portion 120b of the second housing structure 120 and a second portion 110b of the first housing structure 110 parallel to the folding axis (A axis) and not corresponding to the sensor region 131d. In this case, the second width W2 may be formed longer than the first width W1. For example, the recess 101 may be formed to have the first width W1 between the first portion 110a of the first housing structure 110 and the first portion 120a of the second housing structure 120 having a mutually asymmetrical shape, and the second width W2 between the second portion 110b of the first housing structure 110 and the second portion 120b of the second housing structure 120 having a mutually symmetrical shape. In an embodiment, the first portion 110a and the second portion 110b of the first housing structure 110 may be formed to have different distances from the folding axis (A axis). The width of the recess 101 is not limited to the illustrated example. In various embodiments, the recess 101 may also have two or more different widths due to a form of the sensor region 131d or an asymmetrical portion of the first housing structure 110 and the second housing structure 120.

In an embodiment, at least a portion of the first housing structure 110 and the second housing structure 120 may be formed of a metal material or a nonmetal material having a rigidity of a selected size and supporting the display unit 130.

In an embodiment, the sensor region 131d may be formed to have a certain region adjacent to one corner of the first housing structure 110. However, the arrangement, shape, or size of the sensor region 131d is not limited to the illustrated example. For example, in another embodiment, the sensor region 131d may be presented in another corner of the first housing structure 110 or in any region between an upper corner and a lower corner. In a further embodiment, the sensor region 131d may be also arranged in at least a partial region of the second housing structure 120. In a yet another embodiment, the sensor region 131d may be also arranged to extend to the first housing structure 110 and the second housing structure 120. In an embodiment, the foldable device 100 may include components for performing various functions, arranged to be exposed on the front surface of the foldable device 100 through the sensor region 131d or through one or more openings presented in the sensor region 131d. In various embodiments, the components may include, for example, at least one of a front camera device, a receiver, a proximity sensor, an illuminance sensor, an iris recognition sensor, an ultrasonic sensor, or an indicator.

In an embodiment, the first rear cover 140 may be disposed on the second surface 112 of the first housing structure 110, and may have a substantially rectangular periphery. In an embodiment, at least a portion of the periphery may be wrapped by the first housing structure 110. Similarly, the second rear cover 150 may be disposed on the fourth surface 122 of the second housing structure 120, and at least a portion of its periphery may be wrapped by the second housing structure 120.

In the illustrated embodiment, the first rear cover 140 and the second rear cover 150 may have a substantially symmetrical shape with respect to the folding axis (A axis). In another embodiment, the first rear cover 140 and the second rear cover 150 may also include various different shapes. In a further embodiment, the first rear cover 140 may be formed integrally with the first housing structure 110, and the second rear cover 150 may be formed integrally with the second housing structure 120.

In an embodiment, the first rear cover 140, the second rear cover 150, the first housing structure 110, and the second housing structure 120 may present a space in which various components (e.g., printed circuit board, antenna module, sensor module, or battery) of the foldable device 100 may be arranged, through a mutually coupled structure. In an embodiment, one or more components may be arranged or visually exposed on the rear surface of the foldable device 100. For example, one or more components or sensors may be visually exposed through a first rear region 141 of the first rear cover 140. In various embodiments, the sensor may include a proximity sensor, a rear camera device, and/or a flash. In another embodiment, at least a portion of a sub display unit 152 (e.g., second display) may be visually exposed through a second rear region 151 of the second rear cover 150. In another embodiment, the foldable device 100 may also include a speaker module 153 arranged through at least a partial region of the second rear cover 150.

The display unit 130 may be arranged in a space formed by the pair of housing structures 110 and 120. For example, the display unit 130 may be seated in the recess 101 formed by the pair of housing structures 110 and 120, and may be arranged to occupy substantially most of the front surface of the foldable device 100. Accordingly, the front surface of the foldable device 100 may include the display unit 130, a partial region (e.g., periphery region) of the first housing structure 110 adjacent to the display unit 130, and a partial region (e.g., periphery region) of the second housing structure 120. In an embodiment, the rear surface of the foldable device 100 may include the first rear cover 140, a partial region (e.g., periphery region) of the first housing structure 110 adjacent to the first rear cover 140, the second rear cover 150, and a partial region (e.g., periphery region) of the second housing structure 120 adjacent to the second rear cover 150.

In an embodiment, the display unit 130 may mean a display whose at least partial region may be deformed into a flat surface or curved surface. In an embodiment, the display unit 130 may include a folding region 131c, a first region 131a arranged at one side (e.g., right region with respect to the folding region 131c) with respect to the folding region 131c, and a second region 131b arranged at the other side (e.g., left region with respect to the folding region 131c). For example, the first region 131a may be disposed on the first surface 111 of the first housing structure 110, and the second region 131b may be disposed on the third surface 121 of the second housing structure 120. In an embodiment, the division of the regions of the display unit 130 is exemplary, and the display unit 130 may be also divided into a plurality of regions (e.g., four or more or two) depending on a structure or function. In an example, in the embodiment illustrated in FIG. 1, the regions of the display unit 130 may be divided by the folding region 131c extending parallel to a y-axis or the folding axis (A axis), but in another embodiment, the regions of the display unit 130 may be divided with respect to another folding region (e.g., folding region parallel to an x-axis) or another folding axis (e.g., folding axis parallel to the x-axis). The division of the regions of the display described above is merely a physical division by the pair of housing structures 110 and 120 and the hinge structure (e.g., hinge structure 164 of FIG. 3), and in reality, the display unit 130 may display one entire screen through the pair of housing structures 110 and 120 and the hinge structure (e.g., hinge structure 164 of FIG. 3). In an embodiment, the first region 131a and the second region 131b may have an overall symmetrical shape centering on the folding region 131c. However, unlike the second region 131b, the first region 131a may include a notch region (e.g., notch region 133 of FIG. 3) that is cut depending on the presence of the sensor region 131d, but may have a symmetrical shape with the second region 131b in other regions. For example, the first region 131a and the second region 131b may include a portion having a symmetrical shape and a portion having an asymmetrical shape.

Referring to FIG. 2, the hinge cover 165 may be configured to be arranged between the first housing structure 110 and the second housing structure 120 and cover an internal component (e.g., hinge structure 164 of FIG. 3). In an embodiment, the hinge cover 165 may be covered by a portion of the first housing structure 110 and the second housing structure 120, or be exposed to the outside depending on the operating state (flat state or folding state) of the foldable device 100.

In an example, as illustrated in FIG. 1, when the foldable device 100 is in an unfolding state, the hinge cover 165 may not be exposed because the hinge cover 165 is covered by the first housing structure 110 and the second housing structure 120. In an example, as illustrated in FIG. 2, when the foldable device 100 is in a folding state (e.g., completely folding state), the hinge cover 165 may be exposed to the outside between the first housing structure 110 and the second housing structure 120. In an example, when the first housing structure 110 and the second housing structure 120 are in an intermediate state of being folded with a certain angle, the hinge cover 165 may be at least partially exposed to the outside of the foldable device 100 between the first housing structure 110 and the second housing structure 120. In this case, the exposed region may be less than that of the completely folding state. In an embodiment, the hinge cover 165 may include a curved surface.

The operation of the first housing structure 110 and the second housing structure 120 according to the operating state (e.g., flat state and folding state) of the foldable device 100 and each region of the display unit 130 will be described below.

In an embodiment, when the foldable device 100 is in the flat state (e.g., state of FIG. 1), the first housing structure 110 and the second housing structure 120 may be folded with an angle of 180 degrees, and the first region 131a and the second region 131b of the display unit 130 may be arranged to face the same direction. In addition, the folding region 131c may form the same plane as the first region 131a and the second region 131b. In another embodiment, when the foldable device 100 is in the flat state, the first housing structure 110 and the second housing structure 120 may be folded in opposite directions wherein the second surface 112 and the fourth surface 122 face each other, whereby the first region 131a and the second region 131b of the display unit 130 may be also arranged to face opposite directions with respect to each other.

In an embodiment, when the foldable device 100 is in the folding state (e.g., state of FIG. 2), the first housing structure 110 and the second housing structure 120 may be arranged to face each other. The first region 131a and the second region 131b of the display unit 130 may form a narrow angle (e.g., between 0 degrees and 10 degrees) with each other and face each other. The folding region 131c may be formed as a curved surface having at least a certain curvature.

In an embodiment, when the foldable device 100 is in the intermediate state, the first housing structure 110 and the second housing structure 120 may be arranged at a certain angle with each other. The first region 131a and the second region 131b of the display unit 130 may form an angle that is greater than that of the folding state and is less than that of the unfolding state. The folding region 131c may be formed as a curved surface having at least a certain curvature, and the curvature at this time may be less than that in the folding state.

FIG. 3 is an exploded perspective view of a foldable device according to various embodiments of the disclosure.

Referring to FIG. 3, in an embodiment, the foldable device 100 may include the display unit 130, a support member assembly 160, at least one printed circuit board 170, the first housing structure 110, the second housing structure 120, the first rear cover 140, and the second rear cover 150. In this document, the display unit 130 (e.g., first display) may be referred to as a display module or a display assembly.

The display unit 130 may include a display panel 131 (e.g., flexible display panel) and one or more plates 132 or layers on which the display panel 131 is seated. In an embodiment, the one or more plates 132 may include a conductive plate (e.g., copper (Cu) sheet or SUS sheet) arranged between the display panel 131 and the support member assembly 160. In an embodiment, the conductive plate may be formed to have substantially the same region as the display unit 130, and may be formed to have a bendable region facing the folding region of the display unit 130. The plate 132 may include at least one auxiliary material layer (e.g., graphite member) disposed on a back surface of the display panel 131. In an embodiment, the plate 132 may be formed in a shape corresponding to the display panel 131. For example, a partial region of the plate 132 may be formed in a shape corresponding to a notch region 133 of the display panel 131.

The support member assembly 160 may include a first support member 161 (e.g., first support plate), a second support member 162 (e.g., second support plate), a hinge structure 164 arranged between the first support member 161 and the second support member 162, a hinge cover 165 covering the hinge structure 164 when the hinge structure 164 is viewed from the outside, and at least one wiring member 163 (e.g., flexible printed circuit board (FPCB)) crossing the first support member 161 and the second support member 162.

In an embodiment, the support member assembly 160 may be arranged between the plate 132 and the at least one printed circuit board 170. In an example, the first support member 161 may be arranged between the first region 131a of the display unit 130 and a first printed circuit board 171. The second support member 162 may be arranged between the second region 131b of the display unit 130 and a second printed circuit board 172.

In an embodiment, the wiring member 163 and at least a portion of the hinge structure 164 may be arranged inside the support member assembly 160. The wiring member 163 may be arranged in a direction (e.g., x-axis direction) of crossing the first support member 161 and the second support member 162. The wiring member 163 may be arranged in the direction (e.g., x-axis direction) perpendicular to the folding axis (e.g., y-axis or folding axis A of FIG. 1) of the folding region 131c.

In an embodiment, the at least one printed circuit board 170 may include the first printed circuit board 171 arranged at the first support member 161 side, and the second printed circuit board 172 arranged at the second support member 162 side, as mentioned above. The first printed circuit board 171 and the second printed circuit board 172 may be arranged inside a space formed by the support member assembly 160, the first housing structure 110, the second housing structure 120, the first rear cover 140, and the second rear cover 150. Components for implementing various functions of the foldable device 100 may be mounted on the first printed circuit board 171 and the second printed circuit board 172.

In an embodiment, a first space of the first housing structure 110 may include the first printed circuit board 171 arranged in a space formed through the first support member 161, a first battery pack 191 arranged in a position facing a first swelling hole 1611 of the first support member 161, at least one sensor module 181, or at least one camera module 182. The first housing structure 110 may include a window glass 183 arranged in a position corresponding to the notch region 133 of the display unit 130 and protecting the at least one sensor module 181 and the at least one camera module 182. In an embodiment, a second space of the second housing structure 120 may include the second printed circuit board 172 arranged in a second space formed through the second support member 162, or a second battery pack 192 arranged in a position facing a second swelling hole 1621 of the second support member 162. According to an embodiment, the first housing structure 110 and the first support member 161 may be formed integrally. According to an embodiment, the second housing structure 120 and the second support member 162 may also be formed integrally. According to an embodiment, the sub display unit 152 may be arranged in the second space of the second housing structure 120. According to an embodiment, the sub display unit 152 (e.g., second display) may be arranged to be visible from the outside through at least a partial region of the second rear cover 150.

In an embodiment, the first housing structure 110 may include a first rotational support surface 114, and the second housing structure 120 may include a second rotational support surface 124 corresponding to the first rotational support surface 114. The first rotational support surface 114 and the second rotational support surface 124 may include a curved surface corresponding to the curved surface included in the hinge cover 165.

In an embodiment, when the foldable device 100 is in an unfolding state (e.g., state of FIG. 1), the first rotational support surface 114 and the second rotational support surface 124 may cover the hinge cover 165, and may not expose the hinge cover 165 to the rear surface of the foldable device 100, or may expose the hinge cover 165 to the minimum. In an embodiment, when the foldable device 100 is in a folding state (e.g., state of FIG. 2), the first rotational support surface 114 and the second rotational support surface 124 may rotate along the curved surface included in the hinge cover 165 and expose the hinge cover 165 to the rear surface of the foldable device 100 to the maximum.

The foldable device 100 is a device that may be folded or unfolded through the hinge structure, and may include, for example, a notebook computer and a foldable phone, but is not limited thereto.

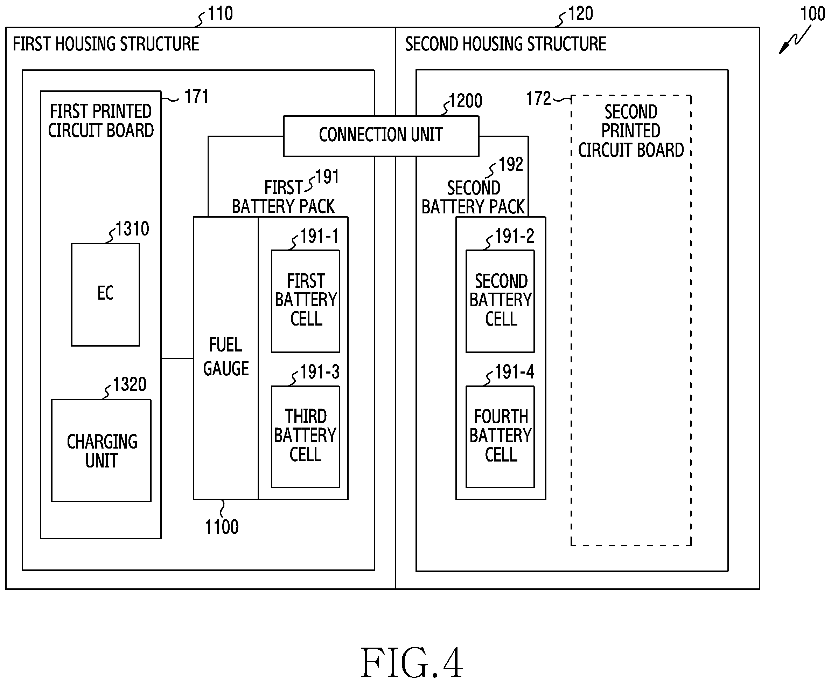

FIG. 4 is a block diagram of a foldable device including a first battery pack and a second battery pack according to an embodiment.

Referring to FIG. 4, the foldable device 100 may include the first housing structure 110 accommodating the first battery pack 191 and the first printed circuit board 171, and the second housing structure 120 accommodating the second battery pack 192 and the second printed circuit board 172. The first battery pack 191 may be electrically connected to the second battery pack 192 through the connection unit 1200 between the first housing structure 110 and the second housing structure 120. The second printed circuit board 172 may be omitted according to an embodiment.

The first battery pack 191 may be arranged within the first housing structure 110, and may be electrically connected to the second battery pack 192 and present power to the foldable device 100.

The first battery pack 191 may include at least one battery cell including a first battery cell 191-1, and a fuel gauge 1100. For example, the first battery pack 191 may include the first battery cell 191-1 and a third battery cell 191-3. The first battery cell 191-1 may be connected in series to the third battery cell 191-3.

The second battery pack 192 may be arranged within the second housing structure 120, and may be electrically connected to the first battery pack 191 and present power to the foldable device 100.

The second battery pack 192 may include at least one battery cell including a second battery cell 191-2. For example, the second battery pack 192 may include the second battery cell 191-2 and a fourth battery cell 191-4. The second battery cell 191-2 may be connected in series to the fourth battery cell 191-4.

The first battery pack 191 may be connected in series to the second battery pack 192. The first battery cell 191-1 of the first battery pack 191 may be connected in series to the second battery cell 191-2 of the second battery pack 192.

In the above, the battery cells 191-3, 191-1, 191-2, and 191-4 in the first battery pack 191 and the second battery pack 192 are described as being connected in series to each other, but the number and connection relationship of the battery cells 191-3, 191-1, 191-2, and 191-4 are not limited thereto. For example, a plurality of battery cells may be connected to each other in a seriesparallel structure such as 4 Serial 1 Parallel (4S1P), 4S2P, 3S1P, 3S2P, 2S1P, or 2S2P. For example, the 4S1P structure may include a structure in which four battery cells are connected in series to each other. For example, the 4S2P structure may include a structure in which four of eight battery cells are connected in series to each other, the remaining four battery cells are connected in series to each other, and the serially connected battery cells are connected in parallel with each other. In addition, for example, some of the serially connected battery cells may be included in the first battery pack 191, and the others may be included in the second battery pack 192.

The fuel gauge 1100 may detect the state of the battery cells within the first battery pack 191 and the second battery pack 192. The fuel gauge 1100 may detect cell voltages of the battery cells and a current flowing in a power path between the battery cells, and may register information about the state of the first battery pack 191, the second battery pack 192, and the battery cells to a registry.

The fuel gauge 1100 may detect cell voltages of the battery cells, and an internal resistance (IR) voltage between the first battery pack 191 and the second battery pack 192. The fuel gauge 1100 may detect a first cell voltage of the first battery cell 191-1, a second cell voltage of the second battery cell 191-2, a third cell voltage of the third battery cell 191-3, a fourth cell voltage of the fourth battery cell 191-4, and an IR voltage between the first battery cell 191-1 and the second battery cell 191-2.

The IR voltage between the first battery cell 191-1 and the second battery cell 191-2 may be used to manage the first battery pack 191 and the second battery pack 192 by considering the change of impedance in a power path between the first battery cell 191-1 and the second battery cell 191-2.

According to an embodiment, an embedded controller (EC) 1310 and a charging unit 1320 may be arranged on the first printed circuit board 171. The first printed circuit board 171 may include a printed circuit board on which components performing and controlling the main operations of the foldable device 100 are mounted.

The EC 1310 may control the charging unit 1320 to be described later, and control the charging and discharging of the battery cells within the first battery pack 191 and the second battery pack 192. The EC 1310 may obtain information about the state of the first battery pack 191 and the second battery pack 192 from the fuel gauge 1100 and, based on the obtained information, the EC 1310 may monitor the charging and discharging state of the battery cells within the first battery pack 191 and the second battery pack 192. The EC 1310 may adjust a charging voltage and a charging current in consideration of the state of the first battery pack 191 and the second battery pack 192. The EC 1310 may determine the safety state of the battery cells within the first battery pack 191 and the second battery pack 192, and control a charging operation of the charging unit 1320.

The charging unit 1320 may present, or block, a charging power to the battery cells within the first battery pack 191 and the second battery pack 192, under the control of the EC 1310. For example, the charging unit 1320 may supply a charging power to the first battery pack 191 arranged within the first housing structure 110, among the first battery pack 191 and the second battery pack 192. For example, the third battery cell 191-3, the first battery cell 191-1, the second battery cell 191-2, and the fourth battery cell 191-4 may be connected in series to each other, and the charging unit 1320 may supply a charging power to the third battery cell 191-3 arranged within the first housing structure 110.

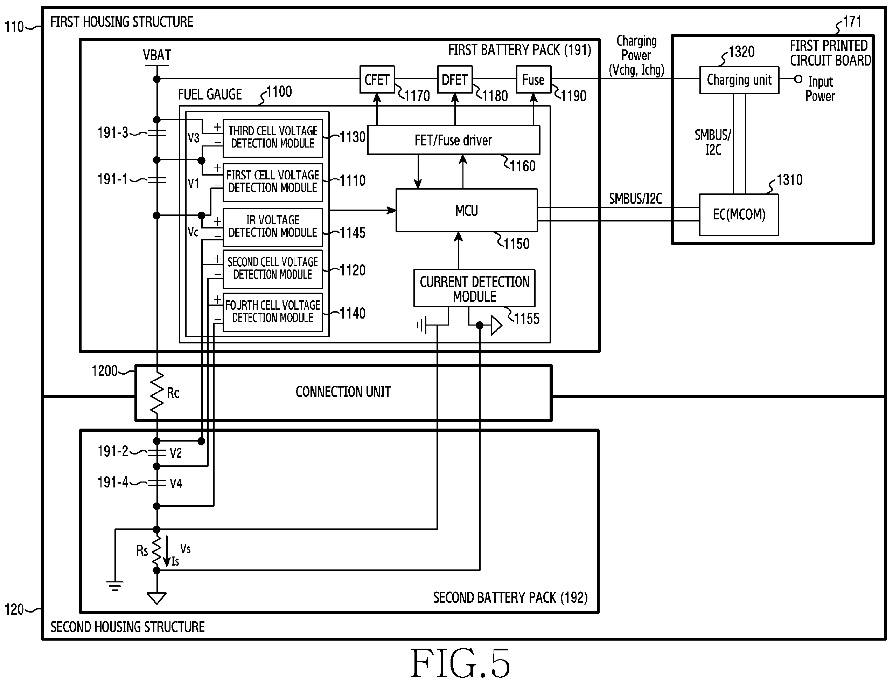

Information about the state of the battery cells within the first battery pack 191 and the second battery pack 192 provided by the fuel gauge 1100, and an embodiment in which the EC 1310 controls the charging unit 1320 by using this information will be described in more detail in FIG. 5.

FIG. 5 is a block diagram of a foldable device for explaining a process of detecting cell voltages of battery cells within a first battery pack and a second battery pack and controlling the charging/discharging of the battery cells according to an embodiment.

Referring to FIG. 5, the first housing structure 110 may accommodate the first battery pack 191 and the first printed circuit board 171, and the second housing structure 120 may accommodate the second battery pack 192.

The first battery pack 191 may include the first battery cell 191-1, the third battery cell 191-3, the fuel gauge 1100, an MCU 1150, a FET/Fuse driver 1160, a CFET 1170, a DFET 1180, and a Fuse 1190, and the fuel gauge 1100 may include a first cell voltage detection module 1110, a second cell voltage detection module 1120, a third cell voltage detection module 1130, a fourth cell voltage detection module 1140, an IR voltage detection module 1145, and a current detection module 1155. The second battery pack 192 may include the second battery cell 191-2 and the fourth battery cell 191-4.

The third battery cell 191-3, the first battery cell 191-1, the second battery cell 191-2, and the fourth battery cell 191-4 may be connected in series to each other. A positive electrode of the third battery cell 191-3 may receive a charging power supplied from the charging unit 1320. A negative electrode of the fourth battery cell 191-4 may be connected to the ground.

In FIG. 5, it is described that two battery cells are included in the first battery pack 191 and two battery cells are included in the second battery pack 192, but the number of battery cells included in the first battery pack 191 and the second battery pack 192 is not limited thereto. For example, one battery cell may be included or three or more battery cells may be included in the first battery pack 191. In addition, for example, one battery cell may be included or three or more battery cells may be included in the second battery pack 192. In this case, the battery cells included in the first battery pack 191 and the second battery pack 192 may be connected in series to each other.

The third cell voltage detection module 1130 may detect a third cell voltage V3 between positive and negative electrodes of the third battery cell 191-3, the first cell voltage detection module 1110 may detect a first cell voltage V1 between positive and negative electrodes of the first battery cell 191-1, the second cell voltage detection module 1120 may detect a second cell voltage V2 between positive and negative electrodes of the second battery cell 191-2, and the fourth cell voltage detection module 1140 may detect a fourth cell voltage V4 between positive and negative electrodes of the fourth battery cell 191-4.

The IR voltage detection module 1145 may detect an IR voltage Vc between the negative electrode of the first battery cell 191-1 and the positive electrode of the second battery cell 191-2. In order to detect the IR voltage Vc, wiring extending from the negative electrode of the first battery cell 191-1 may be connected to the IR voltage detection module 1145 as a path for detection of the IR voltage Vc, and wiring extending from the positive electrode of the second battery cell 191-2 may be connected to the IR voltage detection module 1145 as a path for detection of the IR voltage Vc. For example, a voltage at both terminals of the connection unit 1200 may be detected as the IR voltage Vc by the IR voltage detection module 1145.

The connection unit 1200 may be arranged between the negative electrode of the first battery cell 191-1 and the positive electrode of the second battery cell 191-2, and connect the negative electrode of the first battery cell 191-1 to the positive electrode of the second battery cell 191-2. For example, the connection unit 1200 may include a harness or may be implemented as a flexible printed circuit (FPC). The connection unit 1200 may connect the negative electrode of the first battery cell 191-1 to the positive electrode of the second battery cell 191-2 via the hinge structure between the first housing structure 110 and the second housing structure 120.

The current detection module 1155 may detect a current Is flowing between the battery cell located at the terminal among the battery cells connected in series within the second battery pack 192 and the ground.

For example, when the second battery cell 191-2 is connected in series to the fourth battery cell 191-4 within the second battery pack 192, the positive electrode of the second battery cell 191-2 may be connected to the negative electrode of the first battery cell 191-1, and the negative electrode of the fourth battery cell 191-4 may be connected to the ground. In this case, the current detection module 1155 may detect a current Is flowing between the negative electrode of the fourth battery cell 191-4 and the ground.

When only the second battery cell 191-2 is, for example, included in the second battery pack 192, the positive electrode of the second battery cell 191-2 may be connected to the first battery cell 191-1, and the negative electrode of the second battery cell 191-2 may be connected to the ground. In this case, the current detection module 1155 may detect a current Is flowing between the negative electrode of the second battery cell 191-2 and the ground.

The MCU 1150 may receive the first cell voltage V1 of the first battery cell 191-1, the second cell voltage V2 of the second battery cell 191-2, the third cell voltage V3 of the third battery cell 191-3, the fourth cell voltage V4 of the fourth battery cell 191-4, and the IR voltage Vc between the first battery cell 191-1 and the second battery cell 191-2, from the fuel gauge 1100, and register them to a registry within the MCU 1150. In addition, the MCU 1150 may receive a current Is flowing between the fourth battery cell 191-4 and the ground, from the current detection module 1155, and register them to the registry within the MCU 1150.

The MCU 1150 may control the CFET 1170, the DFET 1180, and the Fuse 1190 by using the FET/Fuse driver 1160, and control the charging and discharging of the battery cells within the first battery pack 191 and the second battery pack 192. The MCU 1150 may transmit a control signal for controlling the CFET 1170, the DFET 1180, and the Fuse 1190, to the FET/Fuse driver 1160, and the FET/Fuse driver 1160 may control the CFET 1170, the DFET 1180, and the Fuse 1190, and control a power path for charging and discharging of the first battery pack 191 and the second battery pack 192, based on the received control signal. For example, the MCU 1150 may transmit a control signal for controlling the CFET 1170 to the FET/Fuse driver 1160, and the CFET 1170 may turn on/off the charging of the battery cells within the first battery pack 191 and the second battery pack 192 under the control of the FET/Fuse driver 1160. For example, the MCU 1150 may transmit a control signal for controlling the DFET 1180 to the FET/Fuse driver 1160, and the DFET 1180 may turn on/off the discharging of the battery cells within the first battery pack 191 and the second battery pack 192 under the control of the FET/Fuse driver 1160. For example, the MCU 1150 may transmit a control signal for controlling the Fuse 1190 to the FET/Fuse driver 1160, and the Fuse 1190 may block a power path for charging/discharging of battery cells within the first battery pack 191 and the second battery pack 192 under the control of the FET/Fuse driver 1160. For example, a current exceeding a limit value may flow to the Fuse 1190 under the control of the FET/Fuse driver 1160 and thus the Fuse 1190 may be opened.

When at least one of the battery cells within the first battery pack 191 and the second battery pack 192 is in an abnormal state, the MCU 1150 may control the CFET 1170, the DFET 1180 and/or the FUSE 1190 and block the charging/discharging of the first battery pack 191 and the second battery pack 192.

The EC 1310 may control the charging/discharging of the battery cells within the first battery pack 191 and the second battery pack 192. The EC 1310 may control the charging unit 1320, and control a charging voltage and charging current presented to the battery cells within the first battery pack 191 and the second battery pack 192. The EC 1310 may control the charging unit 1320, and adjust the magnitude of a charging voltage and charging current presented to the battery cells within the first battery pack 191 and the second battery pack 192.

The EC 1310 may monitor the state of the battery cells within the first battery pack 191 and the second battery pack 192, and control the charging voltage and charging current presented to the battery cells within the first battery pack 191 and the second battery pack 192. The EC 1310 may obtain the first cell voltage V1 of the first battery cell 191-1, the second cell voltage V2 of the second battery cell 191-2, the third cell voltage V3 of the third battery cell 191-3, the fourth cell voltage V4 of the fourth battery cell 191-4, and the IR voltage Vc between the first battery cell 191-1 and the second battery cell 191-2, which are registered to the registry by the MCU 1150. For example, the EC 1310 may read the first cell voltage V1, the second cell voltage V2, the third cell voltage V3, the fourth cell voltage V4, and/or the IR voltage Vc, from the registry, or receive them from the MCU 1150.

The EC 1310 may identify the first cell voltage V1 of the first battery cell 191-1, the second cell voltage V2 of the second battery cell 191-2, the third cell voltage V3 of the third battery cell 191-3, and the fourth cell voltage V4 of the fourth battery cell 191-4, and determine the state of the first battery cell 191-1, the second battery cell 191-2, the third battery cell 191-3, and the fourth battery cell 191-4. The state of the battery cell may include, for example, a remaining life of the battery cell, a charging efficiency of the battery cell, and/or the degree of damage to the battery cell, but is not limited thereto.

The EC 1310 may identify the IR voltage Vc, and compensate a charging voltage Vch presented to the first battery pack 191 and the second battery pack 192 by using the IR voltage Vc. For example, the EC 1310 may control the charging unit 1320 and present the compensated charging voltage (Vch + Vc) to the first battery pack 191 and the second battery pack 192.

The EC 1310 may determine whether at least one of the battery cells within the first battery pack 191 and the second battery pack 192 or the connection unit 1200 is in an abnormal state. The EC 1310 may determine the state of the battery pack by using a current Is flowing between the battery cell located at the terminal among the battery cells connected in series within the second battery pack 192 and the ground. For example, the EC 1310 may determine the state of the battery cells and the connection unit 1200.

By dividing the IR voltage Vc by the current Is, the MCU 1150 may calculate a resistance Rc of a power line between a negative electrode terminal of the first battery cell 191-1 and a positive electrode terminal of the second battery cell 191-2. At least a portion of the power line between the negative electrode terminal of the first battery cell 191-1 and the positive electrode terminal of the second battery cell 191-2 may be included in the connection unit 1200. The EC 1310 may determine the state of the battery pack, based on the change of the resistance Rc calculated by the MCU 1150.

When the resistance Rc calculated by the MCU 1150 is out of a predefined first range, the EC 1310 may determine that the battery pack is in an abnormal state. For example, the EC 1310 may determine that at least one of the battery cells within the first battery pack 191 and the second battery pack 192 or the connection unit 1200 is in the abnormal state. For example, the EC 1310 may determine the damage or non-damage of the connection unit 1200 and/or the state of the battery cells, based on the change of the magnitude of the resistance Rc. In addition, the predefined first range may include, for example, a range exceeding 150% of an initial setting value (for example, initial setting value at a product manufacturing stage) of the Rc, but a numerical value of the predefined first range is not limited thereto. For example, the first range may be set variously depending on design characteristics such as an Rc value and/or the accuracy of a comparator of an ADC.

According to an embodiment, when a difference between the cell voltages of the battery cells within the first battery pack 191 and the second battery pack 192 exceeds a threshold, the EC 1310 may determine that at least one of the battery cells within the first battery pack 191 and the second battery pack 192 is in the abnormal state. For example, when the difference between the cell voltages of the battery cells within the first battery pack 191 and the second battery pack 192 exceeds 200 mV, and there is a difference of 200 mV to 300 mV, the EC 1310 may determine that at least one of the battery cells within the first battery pack 191 and the second battery pack 192 is in the abnormal state, and is in a state in which the abnormality of the battery cell must be notified to a user. In addition, for example, when the difference between the cell voltages of the battery cells within the first battery pack 191 and the second battery pack 192 exceeds 500 mV, the EC 1310 may determine that it is in the abnormal state in which the charging/discharging of the first battery pack 191 and the second battery pack 192 must be blocked. Or, for example, when the difference between the cell voltages of the battery cells within the first battery pack 191 and the second battery pack 192 exceeds 200 mV, the EC 1310 may determine that it is in the abnormal state in which the charging/discharging of the first battery pack 191 and the second battery pack 192 must be blocked. However, the threshold for determining the abnormality of the battery cell is not limited thereto.

According to an embodiment, when there are cell voltages having values equal to or less than the threshold among the cell voltages of the battery cells within the first battery pack 191 and the second battery pack 192, the EC 1310 may determine that at least one of the battery cells within the first battery pack 191 and the second battery pack 192 is in the abnormal state.

When it is determined that at least one of the battery cells within the first battery pack 191 and the second battery pack 192 and the connection unit 1200 is in the abnormal state, the EC 1310 may output an alarm for notifying the abnormal state to the user of the foldable device 100.

For example, the EC 1310 may display a graphical user interface (GUI) including a text notifying that battery repair is needed and/or a text notifying that the connection unit 1200 is damaged, on a screen of the foldable device 100. For example, the EC 1310 may output a sound notifying that the battery repair is needed and/or a sound notifying that the connection unit 1200 is damaged, through a speaker of the foldable device 100.

When the resistance Rc is out of a predefined second range, the MCU 1150 may control the CFET 1170, the DFET 1180, and the Fuse 1190, and block the charging/discharging of the first battery pack 191 and the second battery pack 192. The second range may include a wider range than the first range.

According to an embodiment, the foldable device 100 may separately have the IR voltage detection module 1145, and detect the IR voltage Vc through the IR voltage detection module 1145 by using wiring extending from the negative electrode of the first battery cell 191-1, and enable accurate detection of the cell voltages of the battery cells. In addition, the foldable device 100 may separately detect the IR voltage Vc between the negative electrode of the first battery cell 191-1 and the positive electrode of the second battery cell 191-2, and the cell voltage V2 between the positive electrode of the second battery cell 191-2 and the negative electrode of the second battery cell 191-2, and eliminate the influence of the wiring resistance Rc of the connection unit 1200 on the detecting of the cell voltages of the battery cells. In addition, even when the folding/unfolding operation of the foldable device 100 is repeated and the wiring resistance Rc of the connection unit 1200 is changed, the foldable device 100 may detect the IR voltage Vc changed due to the changed wiring resistance Rc, and may effectively adjust the charging power presented to the battery cells by using the IR voltage Vc.

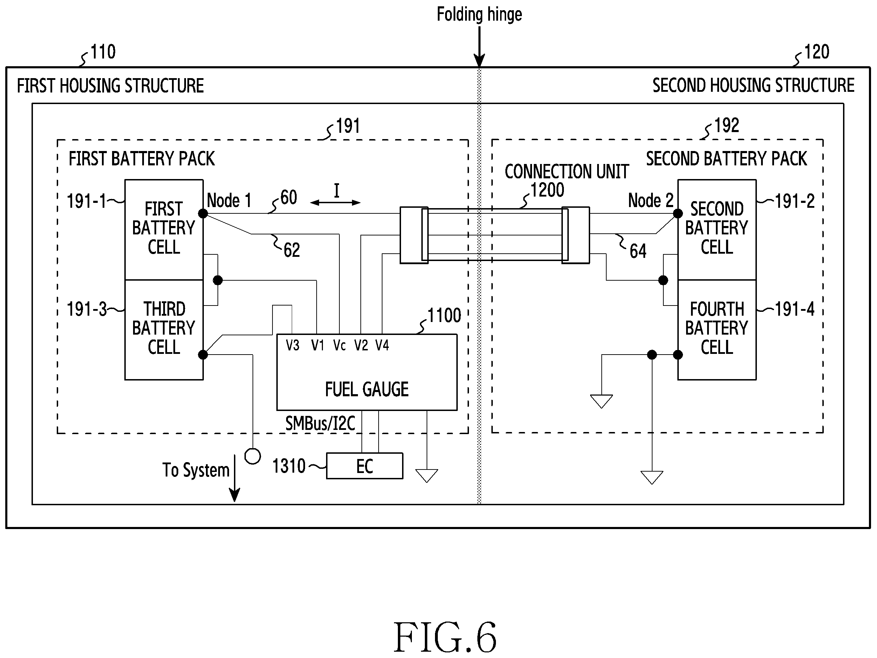

FIG. 6 is a diagram for explaining an additional detection path for detecting a cell voltage of a battery cell according to an embodiment.

Referring to FIG. 6, the first battery pack 191 may be arranged in the first housing structure 110, and the second battery pack 192 may be arranged in the second housing structure 120. The first battery pack 191 may include the first battery cell 191-1, the third battery cell 191-3, and the fuel gauge 1100, and the second battery pack 192 may include the second battery cell 191-2 and the fourth battery cell 191-4.

The negative electrode terminal 'node 1' of the first battery cell 191-1 may be electrically connected to the positive electrode terminal 'node 2' of the second battery cell 191-2 through the connection unit 1200. The 'node 1' may be connected to the 'node 2' by a power line 60 through which power for charging the battery cells passes.

The connection unit 1200 may include a harness or be implemented as a flexible printed circuit (FPC). The connection unit 1200 may connect the 'node 1' to the 'node 2' via a hinge structure between the first housing structure 110 and the second housing structure 120.

According to an embodiment, wiring 62 may be additionally arranged as a detection path for detecting a voltage between the 'node 2' and the 'node 1'. The wiring 62 may be connected to the negative electrode 'node 1' of the first battery cell 191-1, and the fuel gauge 1100. The fuel gauge 1100 may detect an IR voltage between the 'node 1' and the 'node 2' connected by the power line 60, by using the wiring 62 and wiring 64 connecting the 'node 2' to the fuel gauge 1100.

The fuel gauge 1100 may separately detect not only the first cell voltage of the first battery cell 191-1, the second cell voltage of the second battery cell 191-2, the third cell voltage of the third battery cell 191-3, and the fourth cell voltage of the fourth battery cell 191-4, but also the IR voltage between the first battery cell 191-1 and the second battery cell 191-2. Accordingly, even when the connection unit 1200 and/or the power line 60 are damaged as the foldable device 100 repeats the folding and unfolding operations, the accurate cell voltages of the battery cells may be detected regardless of the damage to the connection unit 1200 and/or the power line 60. In addition, the foldable device 100 may separately monitor the degree of damage to the connection unit 1200 and/or the power line 60.

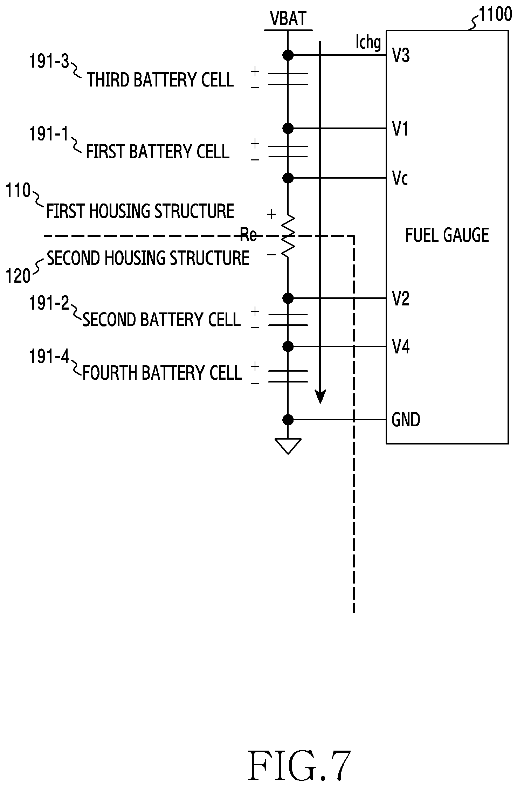

FIG. 7 is a diagram showing an example of detecting cell voltages of battery cells when the battery cells are charged according to an embodiment of the disclosure.

Referring to FIG. 7, while the battery cells are charged, the third cell voltage V3 of the third battery cell 191-3, the first cell voltage V1 of the first battery cell 191-1, the second cell voltage V2 of the second battery cell 191-2, the fourth cell voltage V4 of the fourth battery cell 191-4, and the IR voltage Vc at both terminals of the resistor Rc of the connection unit 1200 may be detected by the fuel gauge 1100.

The fuel gauge 1100 may detect the third cell voltage V3, the first cell voltage V1, the second cell voltage V2, and the fourth cell voltage V4 according to a preset cycle or when a preset event occurs, and register them to the registry within the fuel gauge 1100. The state of each of the third battery cell 191-3, the first battery cell 191-1, the second battery cell 191-2, and the fourth battery cell 191-4 may be monitored based on the third cell voltage V3, the first cell voltage V1, the second cell voltage V2, and the fourth cell voltage V4.

The IR voltage Vc detected by the fuel gauge 1100 may be ignored in determining the state of the battery cells. Accordingly, charging may be prevented from being terminated in a state in which the battery cells are not fully charged, and an abnormal operation may be prevented in which the Fuse 1190 is opened due to an incorrect determination that a voltage difference between the battery cells is large (for example, 0.5 V or more). In addition, the IR voltage Vc may be used to determine a charging voltage to be supplied to the battery cells. For example, the charging voltage may be determined as a magnitude adding the IR voltage to the voltage for charging the battery cells.

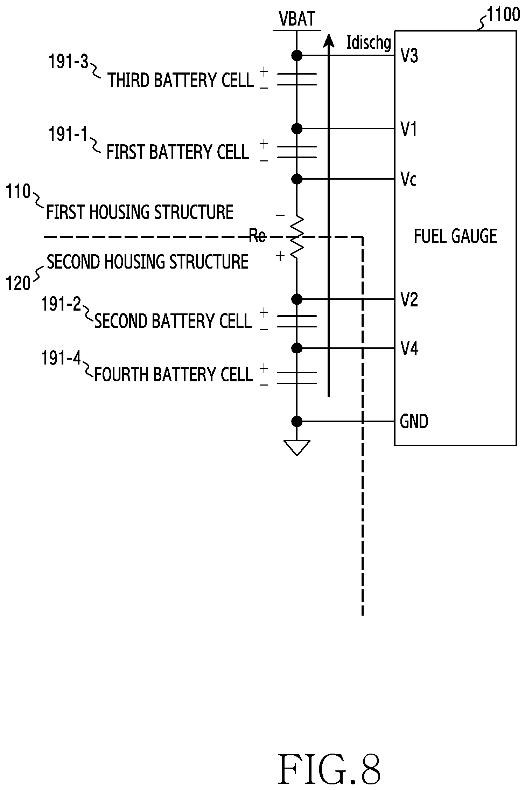

FIG. 8 is a diagram showing an example of detecting cell voltages of battery cells when the battery cells are discharged according to an embodiment of the disclosure.

Referring to FIG. 8, while the battery cells are discharged, the third cell voltage V3 of the third battery cell 191-3, the first cell voltage V1 of the first battery cell 191-1, the second cell voltage V2 of the second battery cell 191-2, the fourth cell voltage V4 of the fourth battery cell 191-4, and the IR voltage Vc at both terminals the resistor Rc of the connection unit 1200 may be detected by the fuel gauge 1100.

The fuel gauge 1100 may detect the third cell voltage V3, the first cell voltage V1, the second cell voltage V2, and the fourth cell voltage V4 according to a preset cycle or when a preset event occurs, and register them to the registry within the fuel gauge 1100. The state of each of the third battery cell 191-3, the first battery cell 191-1, the second battery cell 191-2, and the fourth battery cell 191-4 may be monitored based on the third cell voltage V3, the first cell voltage V1, the second cell voltage V2, and the fourth cell voltage V4.

The IR voltage Vc detected by the fuel gauge 1100 may be ignored in determining the state of the battery cells. Accordingly, discharging may be prevented from being terminated due to incorrect determination that the battery cells are in an over-discharge state (for example, a state in which one or more of the battery cells have a cell voltage of 2.8 V or less) even though the battery cells are not completely discharged.

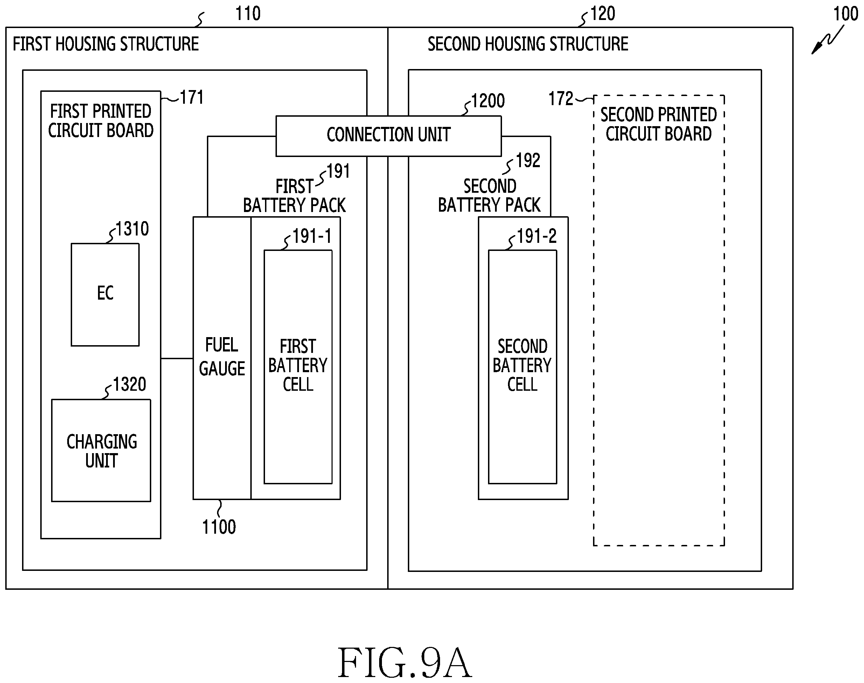

FIG. 9A is a diagram showing an example in which each of the first battery pack 191 and the second battery pack 192 includes one battery cell according to an embodiment.

Referring to FIG. 9A, the first battery pack 191 may include the first battery cell 191-1, and the second battery pack 192 may include the second battery cell 191-2. In this case, the first battery cell 191-1 may be connected in series to the second battery cell 191-2. The positive electrode terminal of the first battery cell 191-1 may receive power presented from the charging unit 1320, and the negative electrode terminal of the first battery cell 191-1 may be connected to the positive electrode terminal of the second battery cell 191-2 through the connection unit 1200. In addition, the negative electrode terminal of the second battery cell 191-2 may be connected to the ground.

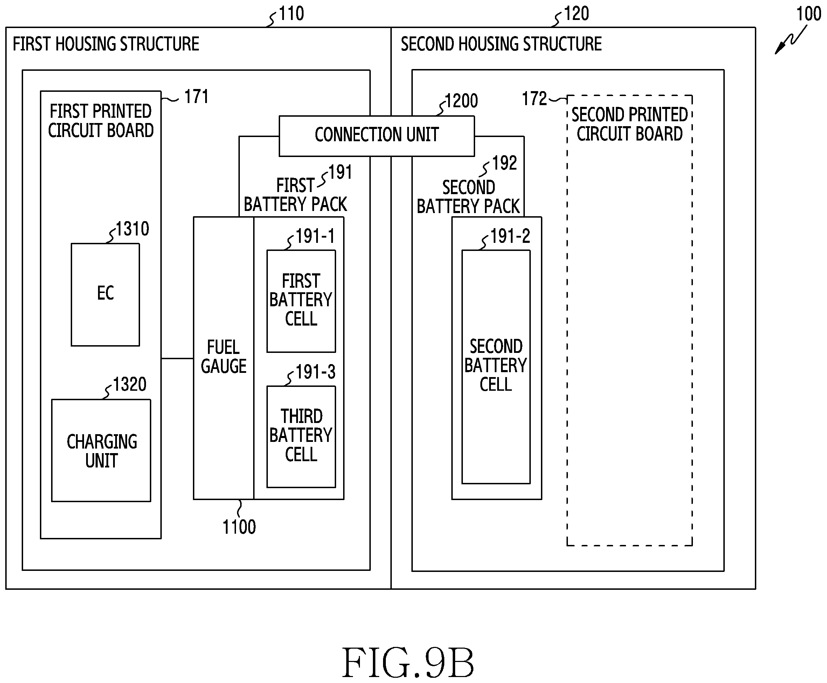

FIG. 9B is a diagram showing an example in which the first battery pack 191 includes two battery cells and the second battery pack 192 includes one battery cell according to an embodiment.

Referring to FIG. 9B, the first battery pack 191 may include the first battery cell 191-1 and the third battery cell 191-3, and the second battery pack 192 may include the second battery cell 191-2. In this case, the first battery cell 191-1, the third battery cell 191-3, and the second battery cell 191-2 may be connected in series to each other. The positive electrode terminal of the third battery cell 191-3 may receive power presented from the charging unit 1320, and the negative electrode terminal of the third battery cell 191-3 may be connected to the positive electrode terminal of the first battery cell 191-1. In addition, the negative electrode terminal of the first battery cell 191-1 may be connected to the positive electrode terminal of the second battery cell 191-2 through the connection unit 1200, and the negative electrode terminal of the second battery cell 191-2 may be connected to the ground.

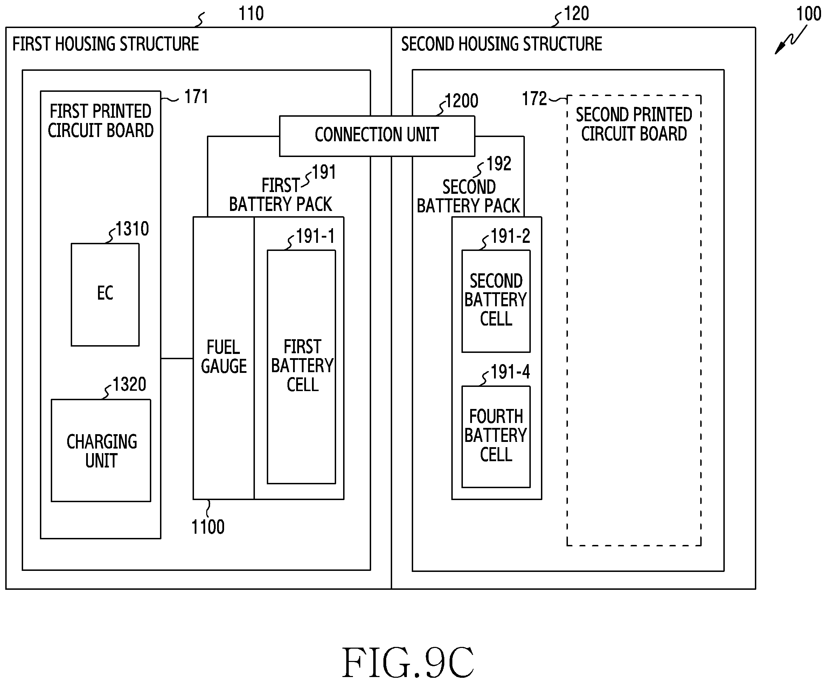

FIG. 9C is a diagram showing an example in which the first battery pack 191 includes one battery cell and the second battery pack 192 includes two battery cells according to an embodiment.

Referring to FIG. 9C, the first battery pack 191 may include the first battery cell 191-1, and the second battery pack 192 may include the second battery cell 191-2 and the fourth battery cell 191-4. In this case, the first battery cell 191-1, the second battery cell 191-2, and the fourth battery cell 191-4 may be connected in series to each other. The positive electrode terminal of the first battery cell 191-1 may receive power presented from the charging unit 1320, and the negative electrode terminal of the first battery cell 191-1 may be connected to the positive electrode terminal of the second battery cell 191-2 through the connection unit 1200. In addition, the negative electrode terminal of the second battery cell 191-2 may be connected to the positive electrode terminal of the fourth battery cell 191-4, and the negative electrode terminal of the fourth battery cell 191-4 may be connected to the ground.

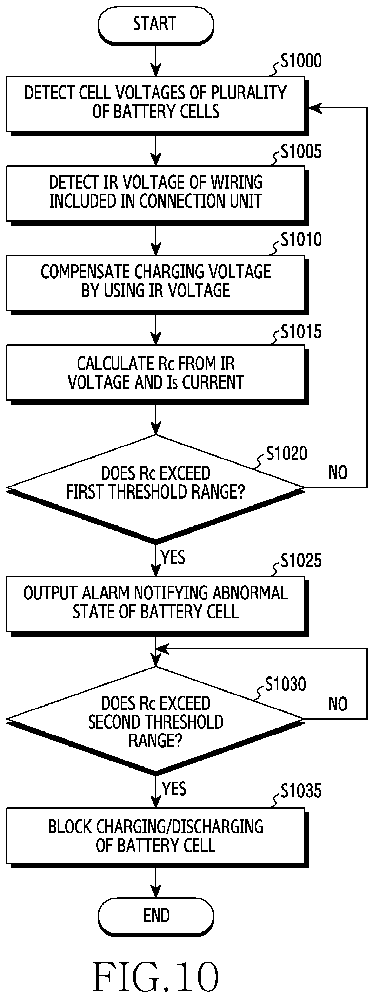

FIG. 10 is a flowchart of a method in which a foldable device manages the state of battery cells according to an embodiment.

Referring to FIG. 10, the foldable device 100 illustrated in FIGS. 1 to 9 may detect cell voltages of battery cells and an IR voltage between the battery cells, compensate a charging voltage, based on the detected voltages, and manage the state of the battery cells.

In operation S1000, the foldable device 100 may detect cell voltages of a plurality of battery cells. The foldable device 100 may detect cell voltages of the first battery cell 191-1 and third battery cell 191-3 within the first housing structure 110 and the second battery cell 191-2 and fourth battery cell 191-4 within the second housing structure 120.

The first housing structure 110 of the foldable device 100 may accommodate the first battery pack 191 and the first printed circuit board 171, and the second housing structure 120 may accommodate the second battery pack 192. The first battery pack 191 may include the first battery cell 191-1, the third battery cell 191-3, the fuel gauge 1100, the MCU 1150, the FET/Fuse driver 1160, the CFET 1170, the DFET 1180, and the Fuse 1190, and the fuel gauge 1100 may include the first cell voltage detection module 1110, the second cell voltage detection module 1120, the third cell voltage detection module 1130, the fourth cell voltage detection module 1140, the IR voltage detection module 1145, and the current detection module 1155. The second battery pack 192 may include the second battery cell 191-2 and the fourth battery cell 191-4.

In operation S1005, the foldable device 100 may detect an IR voltage of wiring included in the connection unit 1200. The foldable device 100 may detect the IR voltage Vc between the negative electrode terminal of the first battery cell 191-1 and the positive electrode terminal of the second battery cell 191-2. The foldable device 100 may connect the negative electrode terminal of the first battery cell 191-1 to the positive electrode terminal of the second battery cell 191-2 by the power line, and at least a portion of the power line may be included in the connection unit 1200.

The negative electrode terminal of the first battery cell 191-1 may be connected to the fuel gauge 1100 through the wiring 62 that is an additionally arranged detection path, and the positive electrode terminal of the second battery cell 191-2 may be connected to the fuel gauge 1100 through the wiring 64. By using the wiring 62 and the wiring 64, the foldable device 100 may detect the IR voltage Vc between the negative electrode terminal of the first battery cell 191-1 and the positive electrode terminal of the second battery cell 191-2.

In operation S 1010, the foldable device 100 may compensate a charging voltage by using the IR voltage. The foldable device 100 may identify the IR voltage Vc, and compensate a charging voltage Vch presented to the first battery pack 191 and the second battery pack 192 by using the IR voltage Vc. For example, the foldable device 100 may add the IR voltage Vc to the charging voltage Vch and determine the compensated charging voltage (Vch + Vc). In addition, the charging unit 1320 may be controlled wherein the compensated charging voltage (Vch + Vc) may be presented to the first battery pack 191 and the second battery pack 192.

In operation S1015, the foldable device 100 may calculate Rc from the IR voltage Vc and the current Is. The foldable device 100 may obtain the current Is flowing between the battery cell located at the terminal among the battery cells connected in series within the second battery pack 192 and the ground, and may divide the IR voltage Vc by the current Is and calculate the resistance Rc of the power line between the negative electrode terminal of the first battery cell 191-1 and the positive electrode terminal of the second battery cell 191-2. At least a portion of the power line between the negative electrode terminal of the first battery cell 191-1 and the positive electrode terminal of the second battery cell 191-2 may be included in the connection unit 1200.

In operation S 1020, the foldable device 100 may determine whether the resistance Rc exceeds a first threshold range.

When the resistance Rc does not exceed the first threshold range as the determination result of operation S1020, the foldable device 100 may perform operation S 1000.

When the resistance Rc exceeds the first threshold range as the determination result of operation S1020, the foldable device 100 may output an alarm notifying an abnormal state of a battery pack in operation S 1025. When the resistance Rc exceeds the first threshold range, the foldable device 100 may determine that at least one of the battery cells within the first battery pack 191 and the second battery pack 192 or the connection unit 1200 is in an abnormal state. For example, when the resistance Rc exceeds the first threshold range, the foldable device 100 may determine that, for example, the connection unit 1200 is damaged. In addition, when a difference between the cell voltages of the battery cells within the first battery pack 191 and the second battery pack 192 exceeds a threshold, the foldable device 100 may determine that at least one of the battery cells within the first battery pack 191 and the second battery pack 192 is in the abnormal state. In addition, when there are cell voltages having values equal to or lower than the threshold among the cell voltages of the battery cells within the first battery pack 191 and the second battery pack 192, the foldable device 100 may determine that at least one of the battery cells within the first battery pack 191 and the second battery pack 192 is in the abnormal state.

When it is determined that at least one of the battery cells within the first battery pack 191 and the second battery pack 192 and the connection unit 1200 is in the abnormal state, the foldable device 100 may output an alarm for notifying the abnormal state to a user of the foldable device 100. For example, the foldable device 100 may display a graphical user interface (GUI) including a text notifying that battery repair is needed and/or a text notifying that the connection unit 1200 is damaged, on a screen of the foldable device 100. For example, the foldable device 100 may output a sound notifying that the battery repair is needed and/or a sound notifying that the connection unit 1200 is damaged, through a speaker of the foldable device 100.

In operation S1030, the foldable device 100 may determine whether the resistance Rc exceeds a second threshold range. The second threshold range may include a wider range than the first threshold range.

When the resistance Rc does not exceed the second threshold range as the determination result of operation S1030, the foldable device 100 may perform operation S1000.

When the resistance Rc exceeds the second threshold range as the determination result of operation S1030, the foldable device 100 may block the charging/discharging of the battery cell in operation S1035.

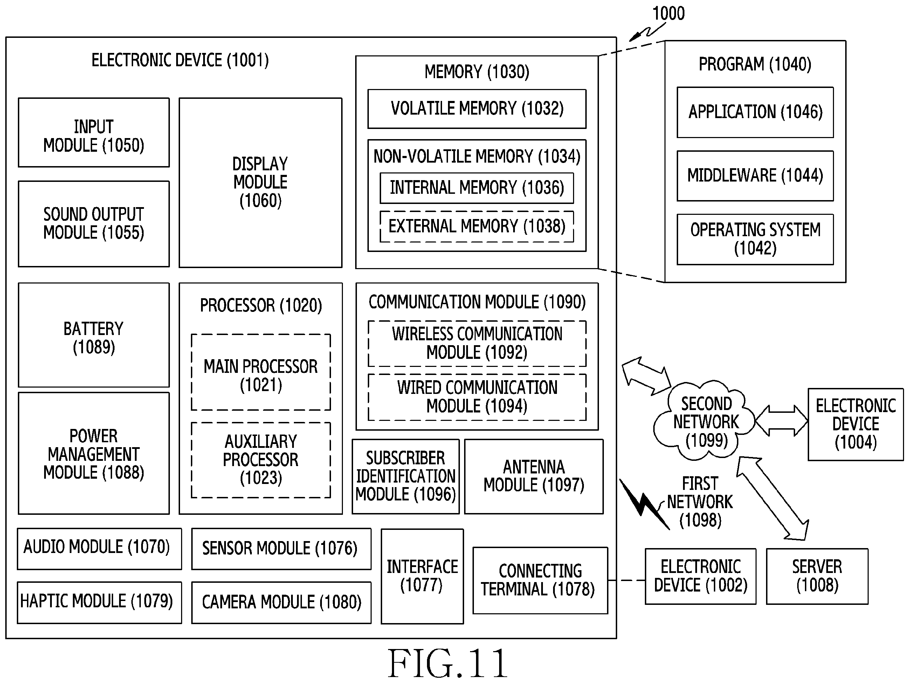

Fig. 11 is a block diagram illustrating an electronic device 1001 in a network environment 1000 according to various embodiments.

Referring to Fig. 10, the electronic device 1001 in the network environment 1000 may communicate with an electronic device 1002 via a first network 1098 (e.g., a short-range wireless communication network), or at least one of an electronic device 1004 or a server 1008 via a second network 1099 (e.g., a long-range wireless communication network). According to an embodiment, the electronic device 1001 may communicate with the electronic device 1004 via the server 1008. According to an embodiment, the electronic device 1001 may include a processor 1020, memory 1030, an input module 1050, a sound output module 1055, a display module 1060, an audio module 1070, a sensor module 1076, an interface 1077, a connecting terminal 1078, a haptic module 1079, a camera module 1080, a power management module 1088, a battery 1089, a communication module 1090, a subscriber identification module(SIM) 1096, or an antenna module 1097. In some embodiments, at least one of the components (e.g., the connecting terminal 1078) may be omitted from the electronic device 1001, or one or more other components may be added in the electronic device 1001. In some embodiments, some of the components (e.g., the sensor module 1076, the camera module 1080, or the antenna module 1097) may be implemented as a single component (e.g., the display module 1060).

The processor 1020 may execute, for example, software (e.g., a program 1040) to control at least one other component (e.g., a hardware or software component) of the electronic device 1001 coupled with the processor 1020, and may perform various data processing or computation. According to one embodiment, as at least part of the data processing or computation, the processor 1020 may store a command or data received from another component (e.g., the sensor module 1076 or the communication module 1090) in volatile memory 1032, process the command or the data stored in the volatile memory 1032, and store resulting data in non-volatile memory 1034. According to an embodiment, the processor 1020 may include a main processor 1021 (e.g., a central processing unit (CPU) or an application processor (AP)), or an auxiliary processor 1023 (e.g., a graphics processing unit (GPU), a neural processing unit (NPU), an image signal processor (ISP), a sensor hub processor, or a communication processor (CP)) that is operable independently from, or in conjunction with, the main processor 1021. For example, when the electronic device 1001 includes the main processor 1021 and the auxiliary processor 1023, the auxiliary processor 1023 may be adapted to consume less power than the main processor 1021, or to be specific to a specified function. The auxiliary processor 1023 may be implemented as separate from, or as part of the main processor 1021.

The auxiliary processor 1023 may control at least some of functions or states related to at least one component (e.g., the display module 1060, the sensor module 1076, or the communication module 1090) among the components of the electronic device 1001, instead of the main processor 1021 while the main processor 1021 is in an inactive (e.g., sleep) state, or together with the main processor 1021 while the main processor 1021 is in an active state (e.g., executing an application). According to an embodiment, the auxiliary processor 1023 (e.g., an image signal processor or a communication processor) may be implemented as part of another component (e.g., the camera module 1080 or the communication module 1090) functionally related to the auxiliary processor 1023. According to an embodiment, the auxiliary processor 1023 (e.g., the neural processing unit) may include a hardware structure specified for artificial intelligence model processing. An artificial intelligence model may be generated by machine learning. Such learning may be performed, e.g., by the electronic device 1001 where the artificial intelligence is performed or via a separate server

(e.g., the server 1008). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 1030 may store various data used by at least one component (e.g., the processor 1020 or the sensor module 1076) of the electronic device 1001. The various data may include, for example, software (e.g., the program 1040) and input data or output data for a command related thererto. The memory 1030 may include the volatile memory 1032 or the non-volatile memory 1034.

The program 1040 may be stored in the memory 1030 as software, and may include, for example, an operating system (OS) 1042, middleware 1044, or an application 1046.

The input module 1050 may receive a command or data to be used by another component (e.g., the processor 1020) of the electronic device 1001, from the outside (e.g., a user) of the electronic device 1001. The input module 1050 may include, for example, a microphone, a mouse, a keyboard, a key (e.g., a button), or a digital pen (e.g., a stylus pen).

The sound output module 1055 may output sound signals to the outside of the electronic device 1001. The sound output module 1055 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 1060 may visually provide information to the outside (e.g., a user) of the electronic device 1001. The display module 1060 may include, for example, a display, a hologram device, or a projector and control circuitry to control a corresponding one of the display, hologram device, and projector. According to an embodiment, the display module 1060 may include a touch sensor adapted to detect a touch, or a pressure sensor adapted to measure the intensity of force incurred by the touch.

The audio module 1070 may convert a sound into an electrical signal and vice versa. According to an embodiment, the audio module 1070 may obtain the sound via the input module 1050, or output the sound via the sound output module 1055 or a headphone of an external electronic device (e.g., an electronic device 1002) directly (e.g., wiredly) or wirelessly coupled with the electronic device 1001.

The sensor module 1076 may detect an operational state (e.g., power or temperature) of the electronic device 1001 or an environmental state (e.g., a state of a user) external to the electronic device 1001, and then generate an electrical signal or data value corresponding to the detected state. According to an embodiment, the sensor module 1076 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 1077 may support one or more specified protocols to be used for the electronic device 1001 to be coupled with the external electronic device (e.g., the electronic device 1002) directly (e.g., wiredly) or wirelessly. According to an embodiment, the interface 1077 may include, for example, a high definition multimedia interface (HDMI), a universal serial bus (USB) interface, a secure digital (SD) card interface, or an audio interface.

A connecting terminal 1078 may include a connector via which the electronic device 1001 may be physically connected with the external electronic device (e.g., the electronic device 1002). According to an embodiment, the connecting terminal 1078 may include, for example, a HDMI connector, a USB connector, a SD card connector, or an audio connector (e.g., a headphone connector).

The haptic module 1079 may convert an electrical signal into a mechanical stimulus (e.g., a vibration or a movement) or electrical stimulus which may be recognized by a user via his tactile sensation or kinesthetic sensation. According to an embodiment, the haptic module 1079 may include, for example, a motor, a piezoelectric element, or an electric stimulator.

The camera module 1080 may capture a still image or moving images. According to an embodiment, the camera module 1080 may include one or more lenses, image sensors, image signal processors, or flashes.

The power management module 1088 may manage power supplied to the electronic device 1001. According to one embodiment, the power management module 1088 may be implemented as at least part of, for example, a power management integrated circuit (PMIC).

The battery 1089 may supply power to at least one component of the electronic device 1001. According to an embodiment, the battery 1089 may include, for example, a primary cell which is not rechargeable, a secondary cell which is rechargeable, or a fuel cell.

The communication module 1090 may support establishing a direct (e.g., wired) communication channel or a wireless communication channel between the electronic device 1001 and the external electronic device (e.g., the electronic device 1002, the electronic device 1004, or the server 1008) and performing communication via the established communication channel. The communication module 1090 may include one or more communication processors that are operable independently from the processor 1020 (e.g., the application processor (AP)) and supports a direct (e.g., wired) communication or a wireless communication. According to an embodiment, the communication module 1090 may include a wireless communication module 1092 (e.g., a cellular communication module, a short-range wireless communication module, or a global navigation satellite system (GNSS) communication module) or a wired communication module 1094 (e.g., a local area network (LAN) communication module or a power line communication (PLC) module). A corresponding one of these communication modules may communicate with the external electronic device via the first network 1098 (e.g., a short-range communication network, such as Bluetooth^{™}, wireless-fidelity (Wi-Fi) direct, or infrared data association (IrDA)) or the second network 1099 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 1092 may identify and authenticate the electronic device 1001 in a communication network, such as the first network 1098 or the second network 1099, using subscriber information (e.g., international mobile subscriber identity (IMSI)) stored in the subscriber identification module 1096.

The wireless communication module 1092 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 1092 may support a high-frequency band (e.g., the mmWave band) to achieve, e.g., a high data transmission rate. The wireless communication module 1092 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 1092 may support various requirements specified in the electronic device 1001, an external electronic device (e.g., the electronic device 1004), or a network system (e.g., the second network 1099). According to an embodiment, the wireless communication module 1092 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 1097 may transmit or receive a signal or power to or from the outside (e.g., the external electronic device) of the electronic device 1001. According to an embodiment, the antenna module 1097 may include an antenna including a radiating element composed of a conductive material or a conductive pattern formed in or on a substrate (e.g., a printed circuit board (PCB)). According to an embodiment, the antenna module 1097 may include a plurality of antennas (e.g., array antennas). In such a case, at least one antenna appropriate for a communication scheme used in the communication network, such as the first network 1098 or the second network 1099, may be selected, for example, by the communication module 1090 (e.g., the wireless communication module 1092) from the plurality of antennas. The signal or the power may then be transmitted or received between the communication module 1090 and the external electronic device via the selected at least one antenna. According to an embodiment, another component (e.g., a radio frequency integrated circuit (RFIC)) other than the radiating element may be additionally formed as part of the antenna module 1097.

According to various embodiments, the antenna module 1097 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 1001 and the external electronic device 1004 via the server 1008 coupled with the second network 1099. Each of the electronic devices 1002 or 1004 may be a device of a same type as, or a different type, from the electronic device 1001. According to an embodiment, all or some of operations to be executed at the electronic device 1001 may be executed at one or more of the external electronic devices 1002, 1004, or 1008. For example, if the electronic device 1001 should perform a function or a service automatically, or in response to a request from a user or another device, the electronic device 1001, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 1001. The electronic device 1001 may provide the outcome, with or without further processing of the outcome, as at least part of a reply to the request. To that end, a cloud computing, distributed computing, mobile edge computing (MEC), or client-server computing technology may be used, for example. The electronic device 1001 may provide ultra low-latency services using, e.g., distributed computing or mobile edge computing. In another embodiment, the external electronic device 1004 may include an internet-of-things (IoT) device. The server 1008 may be an intelligent server using machine learning and/or a neural network. According to an embodiment, the external electronic device 1004 or the server 1008 may be included in the second network 1099. The electronic device 1001 may be applied to intelligent services (e.g., smart home, smart city, smart car, or healthcare) based on 5G communication technology or IoT-related technology.

The electronic device 1001 of FIG. 11 may include the foldable device 100 of FIGS. 1 to 10. In this case, the battery 1089 may include the first battery pack 191 and the second battery pack 192, and the power management module 1088 may include the EC 1310 and the charging unit 1320. Alternatively, the auxiliary processor 1023 may perform the operation of the EC 1310 as well.

The embodiment of the disclosure may also be implemented in the form of a recording medium including instructions executable by a computer, such as a program module executed by the computer. A computer-readable medium may include any available medium that may be accessed by the computer, and may include all volatile and nonvolatile media, and removable and non-removable media. Additionally, the computer-readable medium may include a computer storage medium and a communication medium. A computer storage medium may include volatile and nonvolatile media, and removable and non-removable media, implemented in any method or technology for storing information such as a computer-readable instruction, a data structure, a program module, or other data. The communication medium may typically include other data of a modulated data signal such as a computer-readable instruction, a data structure, or a program module.

Also, in the disclosure, the terms "unit", "module", etc. may include a hardware component such as a processor or a circuit, and/or a software component executed by the hardware component such as the processor.

The "unit" and the "module" may be also implemented by a program that may be stored in an addressable storage medium and be executed by the processor. For example, the "unit" and the "module" may be implemented by components such as software components, object-oriented software components, class components and task components, processes, functions, properties, procedures, subroutines, segments of a program code, drivers, firmware, microcode, circuits, data, databases, data structures, tables, arrays, and variables.

The specific executions described in the disclosure are only an embodiment and do not limit the scope of the disclosure in any way. For the sake of brevity, the description of conventional electronic components, control systems, software, and other functional aspects of the systems may be omitted.

Also, in the disclosure, "including at least one of a, b, or c" may mean "including only a", "including only b", "including only c", "including a and b", "including b and c", "including a and c", or "including all of a, b, and c".

The above description of the disclosure is for exemplary purposes, and those skilled in the art to which the disclosure pertains will understand that the disclosure may be easily modified into other specific forms without changing the technical idea or essential characteristics of the disclosure. Therefore, it should be understood that the embodiments described above are exemplary in all respects and are not restrictive. For example, each component described as a single component may be embodied in a distributed manner, and likewise, components described as distributed may be embodied in a combined manner.

The scope of the disclosure is indicated by the claims described below rather than the detailed description above, and all changes or modifications derived from the meaning and scope of the claims and their equivalent concepts should be interpreted as being included in the scope of the disclosure.

## Claims

1. A foldable device comprising:
a housing unit which comprises a first housing structure and a second housing structure connected using a hinge;
a first battery pack which is accommodated in the first housing structure and comprises a first battery cell;
a second battery pack which is accommodated in the second housing structure and comprises a second battery cell;
a connection unit configured to connect the first battery cell to the second battery cell in series via between the first housing structure and the second housing structure; and
a fuel gauge which is accommodated in the first housing structure and detects a first cell voltage of the first battery cell and a second cell voltage of the second battery cell,
wherein a negative electrode terminal of the first battery cell is electrically connected to a positive electrode terminal of the second battery cell through the connection unit,
wiring connected to the negative electrode terminal of the first battery cell and wiring connected to the positive electrode terminal of the second battery cell are each connected to the fuel gauge, and
the fuel gauge detects an IR voltage between the negative electrode terminal of the first battery cell and the positive electrode terminal of the second battery cell separately from the first cell voltage and the second cell voltage, by using the wiring connected to the negative electrode terminal of the first battery cell and the wiring connected to the positive electrode terminal of the second battery cell.

2. The foldable device of claim 1, wherein the fuel gauge is comprised in the first battery pack accommodated in the first housing structure.

3. The foldable device of claim 1, wherein the fuel gauge comprises an IR voltage detection module for detecting the IR voltage, and
the wiring connected to the negative electrode terminal of the first battery cell and the wiring connected to the positive electrode terminal of the second battery cell are connected to the IR voltage detection module.

4. The foldable device of claim 3, wherein the fuel gauge comprises:
a first cell voltage detection module for detecting the first cell voltage of the first battery cell; and
a second cell voltage detection module for detecting the second cell voltage of the second battery cell.

5. The foldable device of claim 4, wherein the first cell voltage detection module is connected to a positive electrode of the first battery cell and a negative electrode of the first battery cell, and
the second cell voltage detection module is connected to a positive electrode of the second battery cell and a negative electrode of the second battery cell.

6. The foldable device of claim 1, comprising a printed circuit board that is accommodated in the first housing structure and is connected to the first battery pack,
wherein the printed circuit board comprises:
an embedded controller (EC) configured to control the charging of the battery cells within the first battery pack and the second battery pack; and
a charging unit configured to present a charging power to the first battery pack under the control of the EC, and
the EC is configured to compensate a charging voltage for charging the battery cells within the first battery pack and the second battery pack, by using the IR voltage.

7. The foldable device of claim 6, wherein the fuel gauge further comprises a micro controller unit (MCU) configured to register cell voltages detected from the first battery pack and the second battery pack.

8. The foldable device of claim 7, wherein the first battery pack further comprises:
a charging FET (CFET) configured to turn on/off the charging of the battery cells within the first battery pack and the second battery pack;
a discharging FET (DFET) configured to turn on/off the discharging of the battery cells within the first battery pack and the second battery pack; and
a fuse configured to block a power path to the first battery pack.

9. The foldable device of claim 8, wherein the CFET, the DFET, and the fuse are controlled by the MCU.

10. The foldable device of claim 7, wherein the MCU obtains a current Is flowing in a resistor Rs between the second battery cell within the second battery pack and the ground, and
the current Is is used to determine that the connection unit is damaged.

11. The foldable device of claim 10, wherein the EC identifies a resistance Rc obtained by dividing the IR voltage by the obtained current Is, and
outputs an alarm notifying a damage of the connection unit through an output unit of the foldable device when the identified resistance Rc exceeds a predefined range.

12. The foldable device of claim 1, wherein the first battery pack comprises the first battery cell and the third battery cell,
the second battery pack comprises the second battery cell and the fourth battery cell, and
the third battery cell, the first battery cell, the second battery cell, and the fourth battery cell are connected in series to each other.

13. A method for managing a battery in a foldable device, comprising:
detecting cell voltages of battery cells within a first battery pack accommodated in a first housing structure of the foldable device and a second battery pack accommodated in a second housing structure of the foldable device, wherein the first housing structure is connected to the second housing structure through a hinge, the first battery pack comprises a first battery cell, and the second battery pack comprises a second battery cell; and
detecting an IR voltage of a power line comprising a connection unit connecting the first battery cell to the second battery cell in series via between the first housing structure and the second housing structure, wherein a negative electrode terminal of the first battery cell is electrically connected to a positive electrode terminal of the second battery cell through the connection unit,
wherein detecting the IR voltage comprises detecting the IR voltage between the negative electrode terminal of the first battery cell and the positive electrode terminal of the second battery cell separately from the cell voltages, by using wiring connecting a fuel gauge of the foldable device to the negative electrode terminal of the first battery cell, and wiring connecting the fuel gauge to the positive electrode terminal of the second battery cell.

14. The method of claim 13, wherein the fuel gauge is comprised in the first battery pack accommodated in the first housing structure.

15. The method of claim 13, wherein detecting the IR voltage comprises detecting the IR voltage by using the fuel gauge comprising an IR voltage detection module for detecting the IR voltage, and
the wiring connecting the fuel gauge to the negative electrode terminal of the first battery cell and the wiring connecting the fuel gauge to the positive electrode terminal of the second battery cell are connected to the IR voltage detection module.
